# EUROPEAN PATENT APPLICATION

(11) **EP 2 040 299 A1**
(43) Date of publication of application: **25.03.2009**
(21) Application number: 07116253.1
(22) Date of filing: 12.09.2007
(51) Int. Cl.: H01L 29/423, H01L 29/778, H01L 27/06

(54) **Electrical devices having improved transfer characteristics and method for tailoring the transfer characteristics of such an electrical device**

(71) Applicant: Forschungsverbund Berlin e.V., 12489 Berlin (DE)
(72) Inventor: Khalil, M. Ibrahim, 12351 Berlin (DE); Bahat-Treidel, Eldad, 10557 Berlin (DE); Würfl, Hans-Joachim, 15738 Zeuthen (DE); Hilt, Oliver, 15566 Schöneiche (DE)
(74) Representative: Hengelhaupt, Jürgen

(57) **Abstract**

The invention concerns about electrical devices having improved transfer characteristics and a corresponding method of tailoring the transfer characteristics of such electrical devices. According to one aspect of the invention, there is provided an electrical device including at least two transistor segments or at least two transistors connected in parallel or in series characterized in that the at least two segments of the transistor or the at least two of the transistors have a different single transfer characteristic due to at least one of different topology and different material properties.

## Description

The invention concerns about electrical devices having improved transfer characteristics and a corresponding method of tailoring the transfer characteristics of an electrical device.

A drawback of common active electrical devices including at least a transistor, a thyristor or diode is the nonlinearity in operating condition. The main source of nonlinearity in a typical transistor comes from the nonlinearity of transconductance.

Active electrical elements include field effect transistors and bipolar transistors. In field effect transistors, transconductance gₘ is defined as a rate of change of drain current with respect to a rate of change of gate voltage, i.e dI_{d}/dV_{g}, with a constant drain/source voltage. Typical values of gₘ for a small-signal field effect transistor are 1 to 200 mS. A transconductance gₘ of bipolar small-signal transistors varies widely, increasing exponentially with the emitter current. It has a typical range of 1 to 400 mS. An input voltage change is applied between the base/emitter and the output is the change in collector current flowing between the collector/emitter with a constant collector/emitter voltage.

For related patents see: US 6,992,319 Ultra-linear multi-channel field effect transistor; US 5,362,677 Method for producing a field effect transistor with a gate recess structure; US 6,943,386 Pseudomorphic high electron mobility field effect transistor with high device linearity; US 5,838,031 Low noise-high linearity HEMT-HBT composite; US 6,429,467 Heterojunction field effect transistor; US 6,534,801 GaN-based high electron mobility transistor; US 7,026,665 High voltage GaN-based transistor structure; and US 7,161,194 High power density and/or linearity transistors.

According to one aspect of the invention, there is provided an electrical device including at least two transistor segments or at least two transistors connected in parallel or in series characterized in that the at least two segments of the transistor or the at least two of the transistors have a different single transfer characteristic due to at least one of different topology and different material properties.

The term topology refers to the relative position of the specific elements of the transistor to each other. These elements include the gate, source, drain and recess. The transconductance is tailored by changing the relative position of the elements to each other.

The term material property refers to the (chemical) composition of the specific elements of the transistor as well as the modification of the material used. The properties of the material include for example its epitaxy, doping and metallization.

The term transistor segment refers to a specific region of the transistor wherein the transfer segment satisfies its basic scalable functionality.

Preferably, the transistor is a high electron mobility transistor, especially a GaN high electron mobility transistor.

A High Electron Mobility Transistor (HEMT) is a field effect transistor with a junction between two materials with different band gaps (i.e. a heterojunction) as the channel instead of a -doped region. A commonly used combination is GaAs with AlGaAs. The effect of this junction is to create a very thin layer of conducting electrons with rather high concentration, giving the channel very low resistivity. This layer is sometimes called a two-dimensional electron gas. As with all the other types of FETs, a voltage applied to the gate alters the conductivity of this layer. HEMT can also be built with a GaN/AlGaN heterojunction (GaN-HEMT).

The electrical device may be a high power device or a high frequency device.

If the transistor is a field effect transistor the difference in the topology preferably includes a different position of the gate in relation to their drain and source in the at least two field effect transistors, a different recess depth of the gate in the at least two field effect transistors (and thus a different distance of the gate to drain/source) and/or the difference in the material properties includes the use of different gate materials having a different work function in the at least two field effect transistors.

According to another aspect of the invention, there is provided a method of tailoring the transfer characteristic of an electrical device including at least two transistor segments or at least two transistors connected in parallel or series. The method including the steps of:
(i) Selecting a segment of the transistor or at least one of the transistors connected in parallel or in series; and
(ii) Modifying the single transconductance of the selected transistor segment or the selected transistor by amending at least one of its topology and material properties such that the electrical device shows a common total transfer characteristic having a reduced nonlinear behavior.

In other words, the transconductance of an electrical device is tailored by providing transistor segments in a transistor or transistors with intentionally changed transfer characteristics.

In the following, the invention will be described in more detail. The corresponding drawing show:
Fig.1: A sectional view of an exemplary HEMT device
Fig.2: A sectional view of exemplary recess gate HEMT device.
Fig.3: Transfer characteristics dependence of the gate recess depth
Fig. 4: Transconductance (gₘ) characteristics dependence of the gate recess depth
Fig. 5: Resultant transfer and transconductance characteristics of the final device consists of multi-cells
Fig. 6: Mechanism of superimposing the transfer characteristics of different device segments

An improvement of the overall device linearity by paralleling a few HEMT cells having slightly different transfer characteristics is demonstrated further below. This can be in a single device or a power bar (a number of cells bonded in parallel to have very high power from a single device). In case of a single device this method is applicable only if the device is of multi fingers or consists of more than one segment. In the case of power bars each segment may have variation in transfer characteristic. If this variation can be controlled precisely then it is possible to control the overall transconductance such a way so that the intermodulation distortion due to higher order transconductance is minimized.

The idea comes from the fact that the main source of nonlinearity in a typical transistor at weakly linear operating condition comes from the nonlinearity of transfer characteristic. This is due to the higher order transconductance. If in a multi unit transistor or power bar, all the units are identical then the shape of the transfer characteristic curve does not change. If every unit is designed a bit different to have an overall linear transconductance shape then the overall linearity performance will boost up. It might be done in different ways. For example:
(1) Recess Technology: By recessing the gate of a HEMT, the transconductance can be precisely controlled. Controlling the recess depth the threshold voltage can be shifted and the shape of the transconductance curve can be optimized. Shifting the threshold voltage, optimizing the shape and scaling the gate width, it is possible to achieve a great flexibility to engineer the transconductance curve.
(2) Gate position: By changing the gate width and gate position it is also possible to change the shape of the transconductance curve.
(3) Combination of gate metals with different work functions: This gate technology results in different Schottky barrier heights and thus different threshold properties. A suitable combination of for example two different types of gate metallization can be used to engineer the gₘ profile.

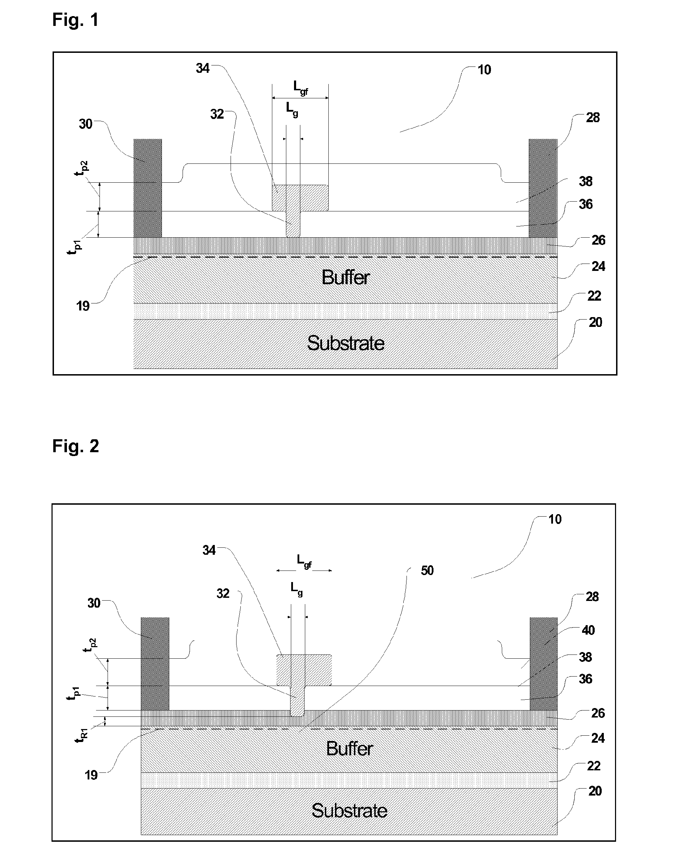

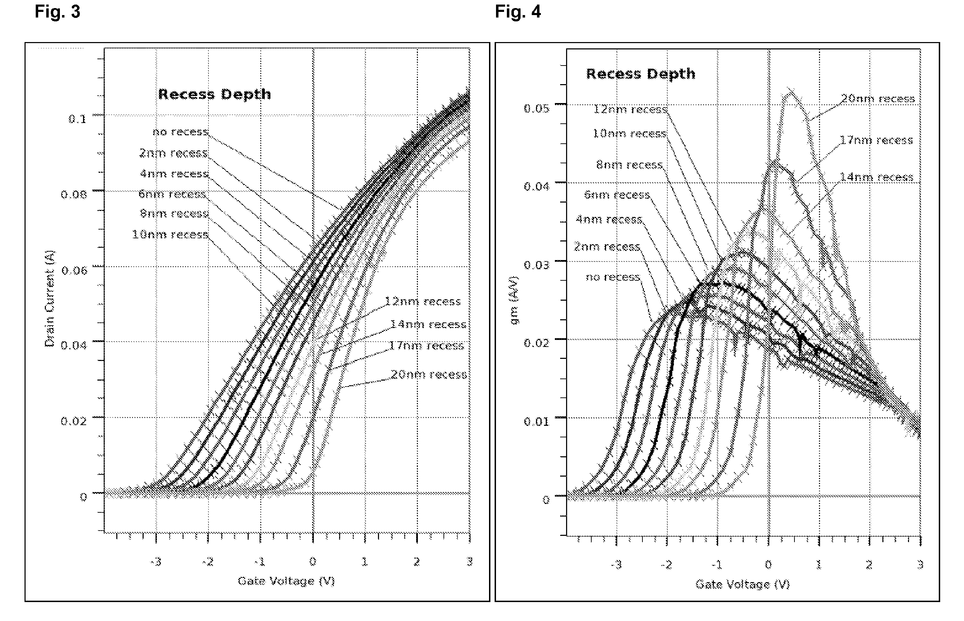

As an example it is presented a multi-cell HEMT power bar. Fig. 1 shows a basic HEMT cell without recess and Fig.2 shows the same with recess. If the gate is recessed with different depth, the transfer characteristic changes. In case of recessing, the depth of tr1 in Fig. 2 will be varied. In Fig. 3 and Fig. 4 the drain current Ids and the transcondutance gₘ are shown at different recess depth when gate voltage Vg is swept. It can be seen that there is a shift in threshold voltage and change in slope at each cell.

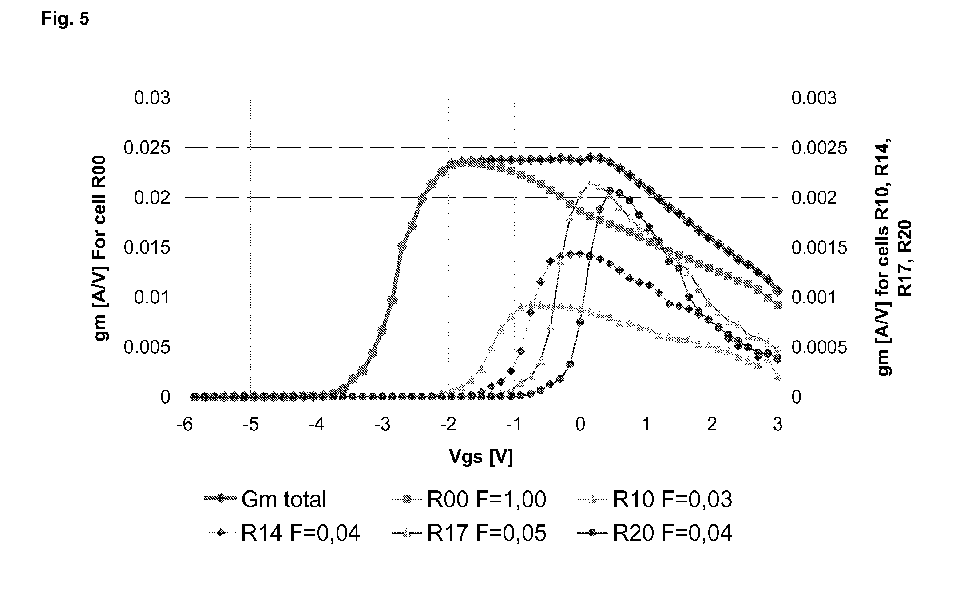

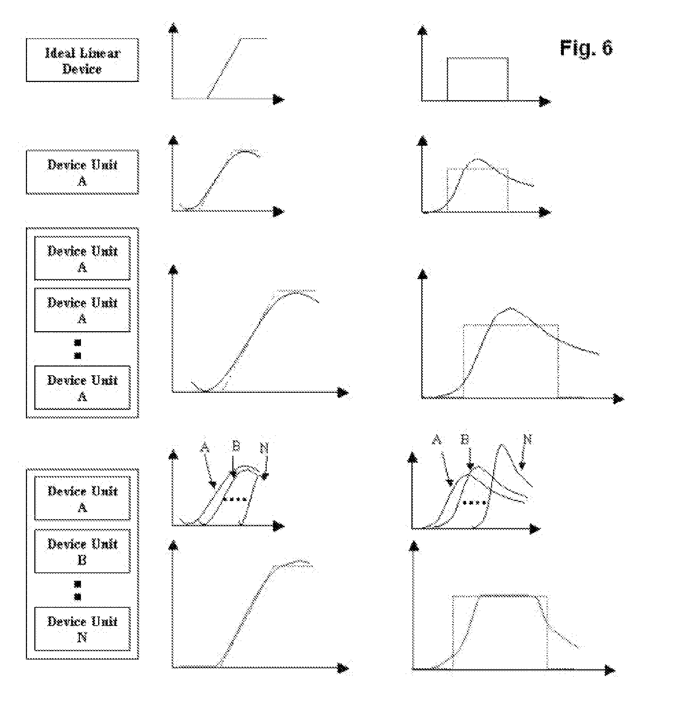

To have a linear device we need a flat gₘ curve where the higher order gₘ's will be zero. A few numbers of recessed cells have been taken (labeled in Fig. 5 as Rxx F = n; here xx is the recess depth in nm and n is the scaling factor) with different recess depth having different transconductance characteristic and combined them. They were precisely optimized and scaled such a way so that the resultant transconductance curve lead to a flat form hence minimum nonlinearity. In Fig 5 the gₘ characteristic of different cells and the resultant gₘ is shown. Fig. 6 shows the mechanism graphically.

**Legend of reference signs:**

| No. | |
|---|---|
| 10 | Example HEMT device |
| 19 | 2DEG |
| 20 | Substrate |
| 22 | Nucleation Layer |
| 24 | 1^{st} Buffer layer |
| 26 | 2^{nd} Barrier layer |
| 28 | Drain electrode and drain pad |
| 30 | Source electrode and Source pad |
| 32 | Gate |
| 34 | Gate electrode pad |
| 50 | 2DEG depleted region |
| L_{gf} | Gate electrode pad length |
| Lg | Gate length |
| tₚ₁ | 1^{st} passivation layer thickness |
| tₚ₂ | 2^{nd} passivation layer thickness |
| t_{R1} | Remaining barrier layer thickness under the recessed gate. |

## Claims

1. An electrical device including at least two transistor segments or at least two transistors connected in parallel or in series **characterized in that** the at least two segments of the transistor or the at least two of the transistors have a different single transfer characteristic due to at least one of different topology and different material properties.

2. The electrical device of claim 1, **characterized in that** the transistor is a high electron mobility transistor.

3. The electrical device of claim 2, **characterized in that** the transistor is a GaN high electron mobility transistor.

4. The electrical device of any of claims 1 through 3, **characterized in that** the electrical device is a high power device.

5. The electrical device of any of claims 1 through 3, **characterized in that** the electrical device is a high frequency device.

6. The electrical device of any of claims 2 to 5, **characterized in that** the transistor is a field effect transistor and the difference in the topology includes a different position of the gate in relation to their drain and source in the at least two field effect transistors.

7. The electrical device of any of claims 2 to 6, **characterized in that** the transistor is a field effect transistor and the difference in the topology includes a different recess depth of the gate in the at least two field effect transistors.

8. The electrical device of any of claims 2 to 7, **characterized in that** the transistor is a field effect transistor and the difference in the material properties includes the use of different gate materials having a different work function in the at least two field effect transistors.

9. Method of tailoring the transfer characteristic of an electrical device including at least two transistor segments or at least two transistors connected in parallel or series, the method including the steps of:
(i) Selecting a segment of the transistor or at least one of the transistors connected in parallel or in series; and
(ii) Modifying the single transconductance of the selected transistor segment or the selected transistor by amending at least one of its topology and material properties such that the electrical device shows a common total transfer characteristic having a reduced nonlinear behavior.

## Amended claims

### Amended claims in accordance with Rule 137(2) EPC.

**1.** An electrical device including at least two recess gate high electron mobility transistor segments or at least two recess gate high electron mobility transistors connected in parallel or in series, wherein the at least two segments of the recess gate high electron mobility transistor or the at least two of the recess gate high electron mobility transistors have a different single transfer characteristic due to a different topology and optionally different material properties, **characterised in that** the different topology includes different recess depths which are selected such that linearity of the electrical device is higher than of each of the at least two recess gate high electron mobility transistor segments or of the at least two recess gate high electron mobility transistors alone.

**2.** The electrical device of claim 1, **characterized in that** the transistor is a GaN high electron mobility transistor.

**3.** The electrical device of claims 1 or 2, **characterized in that** the electrical device is a high power device.

**4.** The electrical device of claims 1 or 2, **characterized in that** the electrical device is a high frequency device.

**5.** The electrical device of any of the preceding claims, **characterized in that** the transistor is a field effect transistor and the difference in the topology includes a different position of the gate in relation to their drain and source in the at least two field effect transistors.

**6.** The electrical device of any of the preceding claims, **characterized in that** the transistor is a field effect transistor and the difference in the material properties includes the use of different gate materials having a different work function in the at least two field effect transistors.
